(19) Europäisches Patentamt

European Patent Office

Office européen des brevets

(11) **EP 1 083 598 A1**

(12) **EUROPEAN PATENT APPLICATION**
published in accordance with Art. 158(3) EPC

(43) Date of publication:
**14.03.2001 Bulletin 2001/11**

(51) Int. Cl.[7]: **H01L 21/82**, H01L 27/04, H01L 21/822

(21) Application number: **00911324.2**

(22) Date of filing: **23.03.2000**

(86) International application number:
**PCT/JP00/01794**

(87) International publication number:
**WO 00/57470 (28.09.2000 Gazette 2000/39)**

(84) Designated Contracting States:
**AT BE CH CY DE DK ES FI FR GB GR IE IT LI LU MC NL PT SE**

(30) Priority: **24.03.1999 JP 7992799**

(71) Applicant:
**Matsushita Electric Industrial Co., Ltd.
Kadoma-shi, Osaka-fu, 571-8501 (JP)**

(72) Inventors:
• **SAKIYAMA, Shiro
Room 101
Kadoma-shi, Osaka 571-0070 (JP)**

• **KINOSHITA, Masayoshi
Hirakata-shi, Osaka 573-0084 (JP)**
• **KAJIWARA, Jun
Kyoto-shi, Kyoto 612-8485 (JP)**
• **YAMAMOTO, Hiroo
Takatsuki-shi, Osaka 569-1145 (JP)**
• **SATOMI, Katsuji
Osaka-shi, Osaka 535-0003 (JP)**

(74) Representative:
**Jeffrey, Philip Michael
Frank B. Dehn & Co.
179 Queen Victoria Street
London EC4V 4EL (GB)**

(54) **METHOD OF DISPOSING LSI**

(57) A LSI layout method for the LSI design of standard cell type is provided, by which sufficient noise suppression of power supply noise as well as sufficient stabilization of power supply can be realized. Power supply capacitor cells are provided as one of the standard cells in addition to logic gate cells provided as one of the standard cells. Next, the capacitance value of the power supply capacitor cells is determined so as to correspond to the drive load capacity value of the logic gate cells, and the power supply capacitor cells are arranged in the vicinity of the respective logic gate cells.

22 power supply capacity cell

21 logic gate cell

F I G. 3

## Description

### TECHNICAL FIELD

This invention relates to a method for stabilizing the power supply in the LSI design using automatic arrangement wiring of standard cells.

### BACKGROUND ART

In the last few years, in accordance with the power increasingly consumed by LSI, LSI tends to generate increased power supply noise. Furthermore, due to the market demand to promote electric power saving, LSI with lower voltage also has been developed. With this development, an operating margin against power supply noise in LSI internal circuits tends to be degraded.

There is a fear that such an increase in power supply noise of LSI may have negative effects on LSI internal circuits. Examples of such negative effects are: (1) deterioration of operating speed, (2) malfunction of circuits, and (3) system malfunction caused by EMI (Electro Magnetic Interference) noise.

For suppression of noise generated from LSI, it has been common to use a method of arranging a power supply capacity inside LSI. This is because the insertion of power supply capacity makes it possible to reduce the alternating current impedance of power supply and to suppress high-frequency noise.

Furthermore, JP5-21711A discloses a method for stabilizing a power supply, which is achieved by arranging the power supply capacity into sections where functional circuits of LSI do not exist. In addition, JP5-283615A discloses a method of efficiently adding power supply capacity by using capacitance between a power supply and an aluminum wire in LSI.

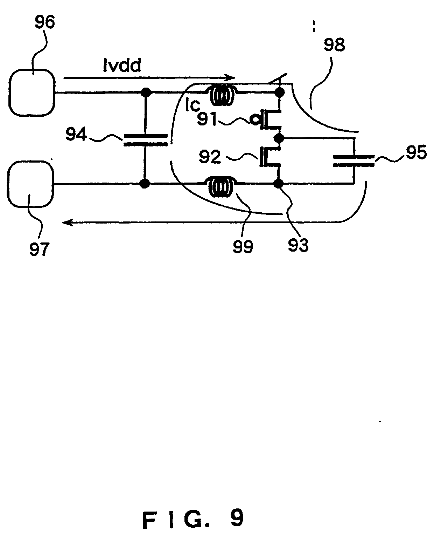

Generally, in using CMOS (Complementary Metal-Oxide Semiconductor) integrated circuits, a charge-discharge current is generated toward load capacity when switching takes place. FIG. 9 illustrates a circuit diagram of a general CMOS integrated circuit. FIG. 9 illustrates a PMOS (P-channel MOS) transistor switch 91, a NMOS (N-channel MOS) transistor switch 92, a ground electrode 93, a power supply capacitor 94, a load capacitor 95, a power supply (Vdd) pad 96, a power supply (Vss) pad 97, a charge current 98, and a parasitic inductor 99.

With reference to FIG. 9, when the PMOS (P-channel MOS) transistor switch 91 is turned on, the charge current 98 (Ivdd) flows from the power supply to the load capacitor 95. When the NMOS (N-channel MOS) transistor switch 92 is turned on, a discharge current to the ground electrode 93 is generated.

The power supply capacitor 94 has accumulated charge energy. The arrangement of the power supply capacitor 94 into the CMOS integrated circuit makes it possible to provide an electric current (Ic) also from the power supply capacitor 94 in addition to the electric current (Ivdd) supplied from the power supply pad 96. Therefore, the variation of current supply from the power supply (Vdd) pad 96 can be controlled.

However, with the increased development of miniature semiconductor integrated circuits in the last few years, the use of an inductor element (L) of an aluminum wire inside LSI tends to increase. Moreover, in using a general CMOS circuit, the parasitic inductor 99 is generated, and this causes power supply noise. More specifically, the power supply noise ($\Delta V$) can be expressed as:

$$\Delta V = L \times di/dt \qquad \text{(Formula 1)}$$

In the formula 1, $di/dt$ represents a variation of electric current. It is clear from Formula 1 that an effective approach for reduction of power supply noise ($\Delta V$) is either to reduce the variation of electric current ($di/dt$) or to reduce the parasitic inductor element L. In other words, the parasitic inductor element L increases in proportion to the length of the aluminum wire, so that it is effective to shorten the power supply line on which a current change takes place.

However, in the conventional method described above, the aluminum wire extending from the switched CMOS gate circuit to the power supply capacity was relatively long, so that the power supply inductor element from the power supply capacity to the switching circuit was increased largely. Therefore, it was difficult to achieve sufficient effectiveness for reduction of power supply noise.

### DISCLOSURE OF THE INVENTION

In order to solve the above mentioned problems, it is an object of the present invention to provide a LSI layout method for the LSI design of standard cell type, by which sufficient noise suppression as well as sufficient stabilization of the power supply can be achieved.

To achieve this purpose, the present invention provides a LSI layout method for the LSI design by automatic arrangement wiring of standard cells, characterized in that power supply capacitor cells are provided as one of the standard cells in addition to logic gate cells provided as one of the standard cells; the capacitance value of the power supply capacitor cells is determined so as to correspond to the drive load capacity value of the logic gate cells to which the power supply capacitor cells are to be arranged; and the power supply capacitor cells are arranged in the vicinity of the logic gate cells.

According to this configuration, the power supply capacitor cells are arranged in the vicinity of the logic gate cells with optimal capacitance values corresponding to the load capacity of the logic gate cells. Thus, noise caused by parasitic inductors can be prevented from increasing, and the power supply noise element can be reduced.

Additionally, in the LSI layout method of the present invention, the capacitance value of the power supply capacitor cells is preferably determined to be substantially twice as large as the drive load capacity value of the logic gate cells. If the capacitance value is determined to be about twice as large as the total load capacity of the logic gate standard cells, the power supply noise can be suppressed to about 1/10 or less of the power supply voltage.

Moreover, in the LSI layout method of the present invention, the power supply capacitor cells preferably are arranged in the vicinity of the logic gate cells, which change simultaneously with clock synchronization. By arranging the power supply capacitor cells in the vicinity of the clock-synchronous logic gates, an area loss can be minimized and the power supply noise can be suppressed efficiently.

Next, to achieve this purpose, the present invention provides a LSI layout method for the LSI design using automatic arrangement wiring of standard cells, characterized in that power supply capacitor cells are provided as one of the standard cells, and that the power supply capacitor cells are arranged in spaces of each block where standard cells are not arranged by automatic arrangement wiring.

According to this configuration, the power supply capacitor is arranged in spaces of each circuit block where standard cells are not arranged (dead space). Thus, the output impedance of power supply can be reduced without increasing the block area, and the power supply noise can be reduced.

BRIEF DESCRIPTION OF THE DRAWINGS

FIG. 1 is a block diagram of LSI;
FIG. 2 is a wiring diagram of a block formed by automatic arrangement wiring;
FIG. 3 is a wiring diagram formed by automatic arrangement wiring, provided with power supply capacitor cells in Embodiment 1 of the LSI layout method of the present invention;
FIG. 4 is a diagram for explanation of deciding the optimal power supply capacity in Embodiment 1 of the LSI layout method of the present invention;
FIG. 5 is an illustrative view of a power supply capacitor in a CMOS semiconductor integrated circuit.
FIG. 6 is an illustrative view of a CTS designed circuit;
FIG. 7 is an illustrative view of a block layout formed by automatic arrangement wiring using conventional standard cells;
FIG. 8 is an illustrative view of a block layout formed by automatic arrangement wiring using standard cells in Embodiment 2 of the LSI layout method of the present invention; and
FIG. 9 is a block diagram of a conventional CMOS integrated circuit.

BEST MODE FOR CARRYING OUT THE INVENTION

Embodiment 1

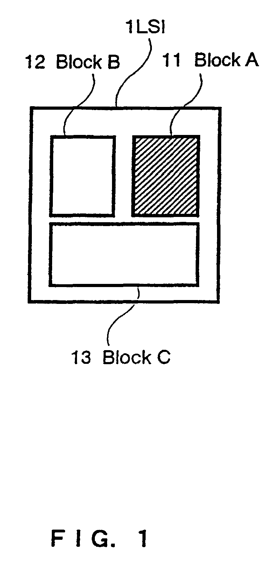

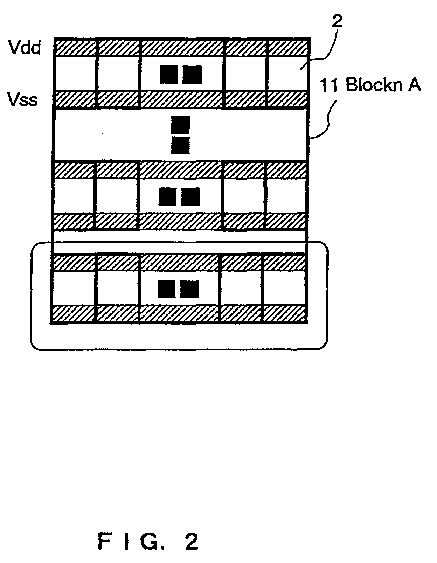

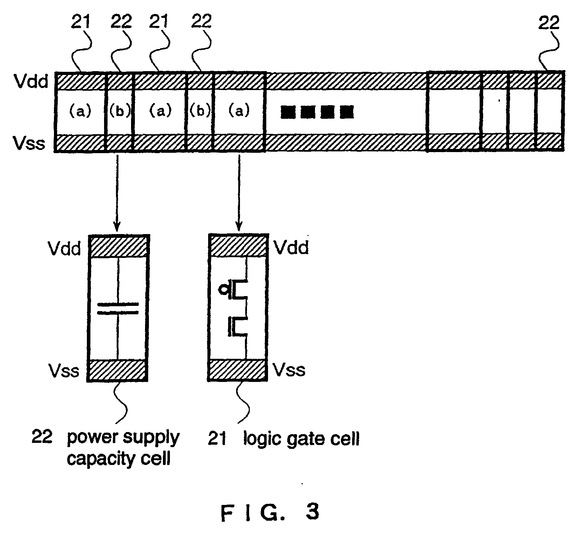

Hereinafter, a first embodiment of the LSI layout method of the present invention will be described with reference to the accompanying drawings. FIG. 1 is a general LSI block diagram; FIG. 2 is a wiring diagram of Block A formed by automatic arrangement wiring; and FIG. 3 is a wiring diagram formed by automatic arrangement wiring, provided with power supply capacitor cells according to the first embodiment of the LSI layout method of the present invention.

FIG. 1 illustrates LSI 1 and circuit blocks 11 to 13 in a block layout using standard cells. As illustrated in FIG. 2, each block is composed of standard cells, and each block is arranged in a rectangular form. The present invention is characterized in that standard cells 22 composed of merely power supply capacitors are prepared in advance as standard cells. The power supply capacitor standard cells 22 axe arranged in accordance with the load capacity of each logic gate standard cell 21, as illustrated in FIG. 3, in the vicinity of logic gate standard cells 21.

Here, the term "vicinity" indicates that the power supply capacitor standard cells 22 are placed adjacent to the respective logic gate standard cells 21, which are used for driving load, and that they are arranged on the same power supply lines. Therefore, when the power supply capacitor standard cells are arranged on different power supply lines, regardless of the closeness of both cells, it is not regarded as being placed in the "vicinity".

Since the power supply capacitor standard cells 22 are arranged in the vicinity of the logic gate standard cells 21, a charge current toward a load capacity generated when each logic gate standard cell is switching can be provided for the most part from the power supply capacitor placed in the vicinity, so that the power supply noise indicated as the power supply inductor element L in Formula 1 can be reduced.

It is generally known that if power supply noise ($\Delta V$) is determined to be about twice as large as the total load capacity of the logic gate standard cells 21, $\Delta V$ can be suppressed to about 1/10 or less of the power supply voltage (Vdd). (P. Larsson, "di/dt Noise in CMOS Integrated Circuits.", Analog Integrated Circuits and Processing, An International Journal Vol. 14, pp.113-129, 1997.)

Furthermore, the fact that the noise is 1/10 or less of the power supply voltage means that, seen from another perspective, the noise corresponds to about 1/2 of the voltage value of a CMOS threshold voltage. Thus, the suppression of the power supply noise to 1/2 of the threshold voltage becomes a particularly significant element for securing reliability in LSI operations.

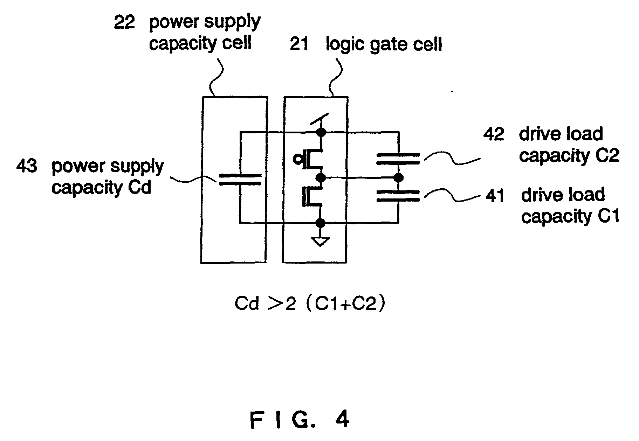

Specifically, as illustrated in FIG. 4 as a cell composition of standard cell type, at the time when an automatic arrangement is executed, drive load capacity of each logic gate (C1+C2) is estimated, and a power supply capacitor standard cell 21 having power supply capacity Cd of at least twice as much as the drive load capacity of each logic gate is placed in the vicinity of each logic gate. In other words, the power supply capacitor standard cell 21 is placed so as to satisfy Cd > 2 (C1+C2). This arrangement assures that the power supply noise (ΔV) can be suppressed to at least 1/10 of the power supply voltage in the respective logic gate circuit. As a result, the peak value of the power supply noise in the LSI as a whole can be certified.

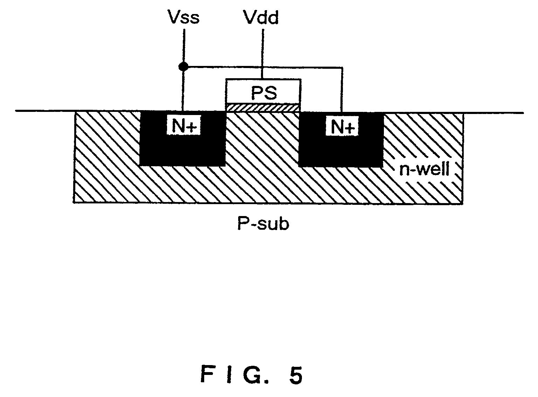

As for the structure of the power supply capacitor, an optimal configuration in a CMOS semiconductor integrated circuit is illustrated in FIG. 5. More specifically, in a p-sub wafer, a n-well is fixed to Vss and a polysilicon gate electrode is fixed to Vdd. The potential of the gate electrode is determined to be forward bias against the n-well, so that depletion layer capacitance is not produced. Therefore, in spite of its small area, a power supply capacitor having a large capacitance value can be realized.

On the other hand, the arrangement of the power supply capacitor standard cells 22 to all the logic gates creates a large area loss. Furthermore, the power supply noise reaches its peak value when a plurality of logic gates switch simultaneously. Generally, in LSI which operates according to a complete clock-synchronous pattern, a large number of logic gates switch when the clock starts. This is because all the DFF (D Flip-Flop) are designed to operate at the start of the clock. Moreover, with the acceleration of LSI in recent years, the reduction of clock skew is desired.

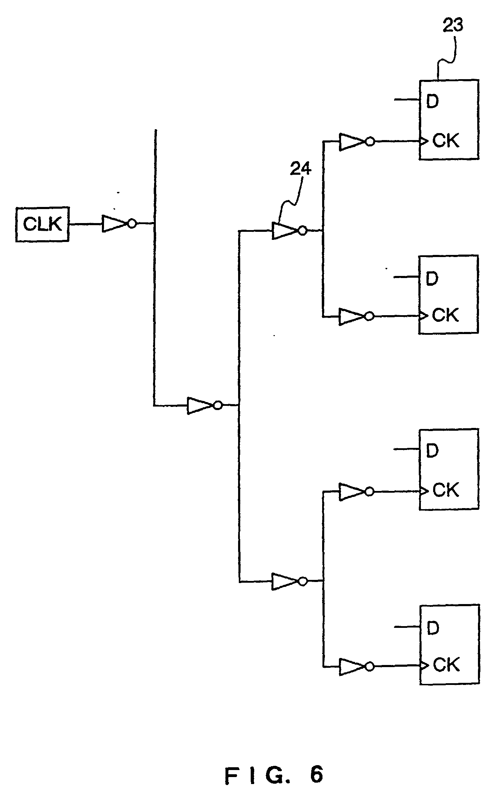

With the foregoing background in mind, a design technique called CTS (Clock tree Synthesis) is more and more standardized. This method is one of those methods that can adjust timing so that phases of all the DFF operations become the same. This timing adjustment can be executed by inverter delays in view of wiring delays. FIG. 6 illustrates a typical example of a LSI design using the CTS method. In FIG. 6, DFF standard cells 23 and inverter standard cells 24 are illustrated. The clock phases of all the DFF standard cells can be adjusted to become the same by changing the size etc. of the inverter according to the load capacity, or by adjusting the number of stage of the inverter delays and so forth.

As a result of the high precision achieved by the CTS method, all the DFF now execute switching simultaneously. The problem of power supply noise is most crucial in such a case. Therefore, in view of the balance to be attained between the area reduction of LSI as a whole and the noise suppression effects, the most effective way is to use the above CTS method only for synchronous type logic gates (DFF gates or inverter gates used for CTS etc.) in arranging the power supply capacitor standard cells 22.

According to the first embodiment described above, power supply capacitor cells are newly prepared in the conventional LSI layout method using standard cells, and the power supply capacitor cells with an optimal capacitance value corresponding to the load capacity of logic gate cells are arranged in the vicinity of the logic gate cells. As a result, power supply noise caused by parasitic inductors can be prevented from increasing, and the power supply noise element can be reduced. Furthermore, when the above method is applied only to clock-synchronous type logic gates, the area loss can be kept to a minimum, and the power supply noise can be suppressed efficiently.

Embodiment 2

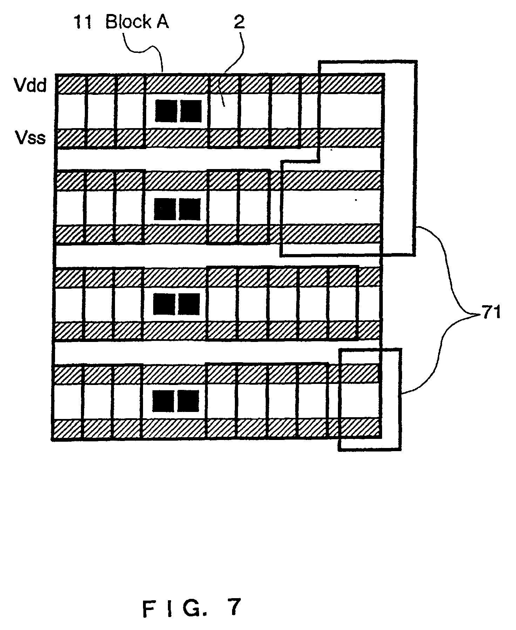

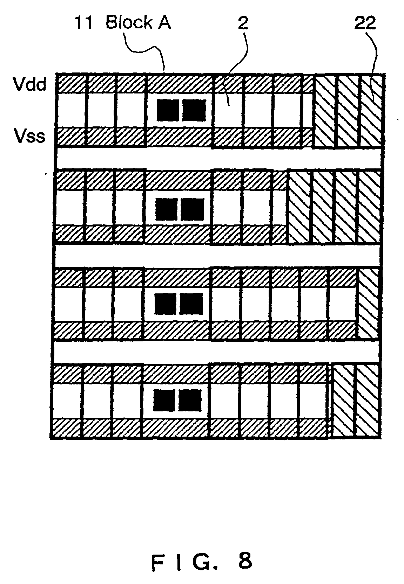

Next, a second embodiment of the LSI layout method of the present invention will be described with reference to the accompanying drawings. FIG. 7 is a block layout formed by automatic arrangement wiring using conventional standard cells. As illustrated in FIG. 7, the conventional configuration allows dead spaces 71 to exist, which are empty spaces in blocks where standard cells are not arranged. This is due to the following reason. Each block is composed of a plurality of power supply lines on which standard cells are arranged. Since each power supply line is provided with a different number of standard cells, the width of the block in each power supply line differs accordingly, producing these dead spaces. In the second embodiment, as illustrated in FIG. 8, the power supply capacitor standard cells 22 are arranged in these dead spaces 71. Accordingly, the power supply capacitor cells can be arranged efficiently without changing the conventional configuration of the block 11 and the total block area.

Generally, as the power supply capacitor becomes larger, the output impedance of the power supply is reduced. Therefore, to suppress power supply noise effectively, it is advantageous to arrange as many power supply capacitor cells as possible. On the other hand, the block area is physically limited. The second embodiment makes it possible to add power supply capacitor cells without enlarging the total block area. This embodiment can be realized easily by preparing the power supply capacitor cells 22 as standard cells, calculating the possible number of the power supply capacitor cells 22 to be arranged based on the width of the dead spaces of the power supply and the width of the power supply capacitor cells 22, and arranging as many power supply capacitor cells 22 as possible.

According to the second embodiment described above, the power supply capacitor cells 22 are newly prepared, and the power supply capacitor cells 22 are arranged as much as possible in the dead spaces 71, which always existed in each circuit block when automatic arrangement wiring was executed by the conventional method. As a result, the output impedance of power supply can be reduced without enlarging the total block area, and the power supply noise can be reduced effectively.

Semiconductor integrated circuits designed with the use of this method have the advantages of generating less power supply noise and preventing malfunction of circuits from occurring and so forth. Therefore, by applying this semiconductor integrated circuit to various systems and devices, systems and devices with improved quality can be provided.

Moreover, the embodiments described above are only examples of the present invention and do not limit the present invention thereto. The subject matter of the present invention is only limited by claims.

INDUSTRIAL APPLICABILITY

According to the LSI layout method of the present invention described above, in the conventional LSI design using standard cells, power supply capacitor cells with an optimal capacitance value corresponding to the load capacity of logic gate cells are arranged in the vicinity of the logic gate cells. Thus, compared with the conventional LSI layout method, the L-Element of wires in the power supply can be reduced, so that the power supply noise can be suppressed effectively.

Furthermore, the LSI layout method of the present invention is applied only to logic gates of dock-synchronous type, so that the area loss can be kept to a minimum, and the power supply noise can be suppressed efficiently.

In addition, according to the LSI layout method of the present invention, power supply capacitor cells are arranged in dead spaces which were already available in each circuit block. This configuration enables the reduction of output impedance of power supply without enlarging the total block area and also the reduction of power supply noise.

**Claims**

1. A LSI layout method for a LSI design by automatic arrangement wiring of standard cells, comprising the operations of:

   providing power supply capacitor cells as one of the standard cells in addition to logic gate cells provided as standard cells,
   determining a capacitance value of the power supply capacitor cells so as to correspond to a drive load capacity value of the logic gate cells to which the power supply capacitor cells are to be arranged, and
   arranging the power supply capacitor cells in the vicinity of the logic gate cells.

2. The LSI layout method according to claim 1, wherein the capacitance value of the power supply capacitor cells is determined to be substantially twice as large as the drive load capacity value of the logic gate cells.

3. The LSI layout method according to claim 1, wherein the power supply capacitor cells are arranged in the vicinity of the logic gate cells which change simultaneously with clock synchronization.

4. A LSI layout method for a LSI design by automatic arrangement wiring of standard cells, comprising the operations of:

   providing power supply capacitor cells as one of the standard cells, and
   arranging the power supply capacitor cells in spaces of each block where standard cells are not arranged by the automatic arrangement wiring.

1LSI

12 Block B    11 Block A

13 Block C

F I G.  1

**F I G. 2**

21    22    21    22                                    22

Vdd

| (a) | (b) | (a) | (b) | (a) | ■ ■ ■ ■ | | | | | |

Vss

Vdd                          Vdd

Vss                          Vss

22   power supply            21   logic gate cell
     capacity cell

F I G.  3

22 power supply
capacity cell        21   logic gate cell

43 power supply
capacity Cd

42 drive load
capacity C2

41 drive load
capacity C1

Cd > 2 (C1+C2)

F I G. 4

Vss    Vdd

PS

N+    N+

n-well

P-sub

F I G. 5

F I G. 6

11 Block A 2

Vdd

Vss

71

F I G. 7

EP 1 083 598 A1

F I G. 8

13

F I G. 9

EP 1 083 598 A1

# INTERNATIONAL SEARCH REPORT

| International application No. |
|---|
| PCT/JP00/01794 |

**A. CLASSIFICATION OF SUBJECT MATTER**
Int.Cl⁷  H01L 21/82, H01L 27/04, H01L 21/822

According to International Patent Classification (IPC) or to both national classification and IPC

**B. FIELDS SEARCHED**

Minimum documentation searched (classification system followed by classification symbols)
Int.Cl⁷  H01L 21/82, H01L 27/04, H01L 21/822

Documentation searched other than minimum documentation to the extent that such documents are included in the fields searched
Jitsuyo Shinan Koho          1922-1996     Toroku Jitsuyo Shinan Koho  1994-2000
Kokai Jitsuyo Shinan Koho  1971-2000       Jitsuyo Shinan Toroku Koho  1996-2000

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP, 7-106521, A (NEC Corporation), 21 April, 1995 (21.04.95), Full text; Figs. 1 to 3 (Family: none) | 1-3 |
| Y | JP, 10-150148, A (Denso Corporation), 02 June, 1998 (02.06.98), Par. No. [0033] (Family: none) | 1-3 |
| Y | Analog Integrated Circuits and Signal Processing, Vol.14, (1997), P. Larsson, "di/dt Noise in CMOS Integrated Circuits", p.113-129, especially, see p.117-118 | 2 |
| Y | JP, 10-107235, A (Hitachi, Ltd.), 24 April, 1998 (24.04.98), Par. No. [0027] (Family: none) | 3 |
| X | JP, 10-326833, A (NEC Corporation), 08 December, 1998 (08.12.98), Full text; Figs. 1 to 3 (Family: none) | 4 |

| ☐ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 10 May, 2000 (10.05.00) | 23 May, 2000 (23.05.00) |

| Name and mailing address of the ISA/ | Authorized officer |
|---|---|
| Japanese Patent Office | |
| Facsimile No. | Telephone No. |

Form PCT/ISA/210 (second sheet) (July 1992)

15